# EUROPEAN PATENT APPLICATION

(11) **EP 4 560 922 A1**
(43) Date of publication of application: **28.05.2025**
(21) Application number: 23212353.9
(22) Date of filing: 27.11.2023
(51) Int. Cl.: H03K 17/97, H03K 17/955, E05B 81/76, H03K 17/96

(54) **ACTUATION UNIT FOR MOTOR VEHICLES**

(71) Applicant: HUF Hülsbeck & Fürst GmbH & Co. KG, 42551 Velbert (DE)
(72) Inventor: COSTEA, Liviu, 727301 Horodnic de Jos Suceava (RO)
(74) Representative: Zenz Patentanwälte Partnerschaft mbB

(57) **Abstract**

An actuator unit comprising a housing (11a, 11b), with a printed circuit board (2), wherein the printed circuit board (2) is mounted in the housing (11a, 11b) and comprises an inductive sensor (3a, 3b). A metallic target (4a, 4b) is associated with the inductive sensor, wherein the target (4a, 4b) extends in sections between the inductive sensor (3a, 3b) and the housing (11a, 11b). The target (4a, 4b) is associated with support means (5a) on the circuit board (2) or the housing and rests on the support means (5a) and/or is attached to the support means, and wherein the target (4a, 4b) is elastic at least in sections. The target (4a, 4b) abuts the housing (11a, 11b) in a section extending over the inductive sensor (3a, 3b) and is in a compressed state between the housing (11a, 11b) and the support means (5a) within the elasticity range of the target (4a, 4b).

## Description

The invention relates to an Actuation unit for a motor vehicle. In particular, the invention relates to an Actuation unit in the form of a door or flap actuator or handle for a motor vehicle.

The housing of the Actuation unit can be attached to a motor vehicle in order to operate doors, flaps or other functions of the motor vehicle. The housing can have an external shape that forms a grippable or graspable handle for the user and it can be made up of several parts. The housing has cavities, at least in sections, to accommodate functional components, in particular electronic components, in the housing. These components can be inserted into a housing part before the housing is closed by connecting it to other housing parts.

Inside the housing is a printed circuit board that is secured in the enclosure. This circuit board forms the basis for the electronic components of the Actuation unit and has conductor tracks and electronic components. In particular, an inductive sensor is arranged on the circuit board.

Inductive sensors, also known as inductive proximity switches or initiators, are widely used in automation and process engineering as well as in the automotive industry and are used for various applications in vehicles. Inductive sensors have the advantage that they work without mechanical contact adjustment and are hardly susceptible to wear and contamination. They are characterized by high reliability. They are used both for recording technical processes in the vehicle (e.g. ABS) and for recording interactions with the user. Inductive sensors work according to the principle of the change in impedance of a conductive coil, which is caused by eddy currents in a conductive target sensed by the sensor. The sensor can be excited by an oscillator, for example, which generates an electromagnetic field that interacts with the nearby (galvanically decoupled) target.

Signal processing electronics detect the change in impedance of the coil when the distance between the sensor (conductive coil) and the target changes and convert it into a usable displacement signal. Signal processing can be carried out using a circuit derived, for example, from the use or combination of the following types of circuit: Colpitts circuit, phase circuit and bridge circuit (e.g. Maxwell bridge). The metallic target, whose change in position relative to the sensor is detected, is assigned to the sensor in the Actuation unit and is accommodated in the housing of the vehicle door handle in its detection area. The target extends in sections between the inductive sensor and the housing. It is therefore located near the sensor and inside the housing.

Such an arrangement of a vehicle door handle with a housing, in which an inductive sensor is accommodated, and a metallic target assigned to the sensor can be used to detect the effects of force on the door handle. If an application of force leads to a deformation of the housing, a target attached to the housing is moved, which is detected by the inductive sensor inside the housing. In the prior art, the target is attached to the inside of the housing, e.g. as a metal foil or metal component, so that a force applied to the outside of the housing in the area of the attachment leads to a movement of the target relative to the inductive sensor, which is attached to the circuit board in the housing and fixed in a fixed position.

When mounting such an Actuation unit with inductive detection of housing deformations caused by the application of force, however, care must always be taken to ensure that the target is aligned precisely and correctly with the inductive sensor. The target must be mounted at a defined distance on the inside of the housing of the Actuation unit. It must also be positioned within the detection range of the inductive sensor coil. Deviations during installation can lead to a deterioration in the sensitivity of the sensor if, for example, the target on the housing is not positioned exactly in the detection range of the inductive sensor. However, this can certainly occur, especially since the target is usually attached to a first housing part, which is initially separated from a further housing part, which accommodates the printed circuit board with the inductive sensor, before assembly, and the co-operating components are only aligned when the housing parts are joined together, so that subsequent position correction is no longer possible.

The task of the invention is to create an Actuation unit in the form of a vehicle door handle that is less prone to errors during assembly and enables reproducible alignment of the targets for detecting a housing deformation relative to an inductive sensor at all times.

This task is solved by a vehicle door handle with the features of claim 1.

According to the invention, support means on the printed circuit board and/or the housing are associated with the target. In this context, the term " support means" is to be understood as any fastening means, receptacles or supports on which the metallic target is supported and held or fixed in any other way. Accordingly, the support means can also have means for connecting the target to the support means, in particular by a force-fit, form-fit or material-fit connection of the target to the support means. The support of the target can be formed on the printed circuit board itself, for example in the case of support means in the form of holes into which the feet of the target are inserted, or in the case of support means in the form of soldering points to which the target is attached with a material bond. In the case of multi-part housings in particular, however, it is also possible to form support means in the housing part that also accommodates the printed circuit board and to arrange the target independently of the printed circuit board on support means in the housing.

In the embodiment according to the invention, the target is elastic at least in sections. The elasticity of the target can be achieved, for example, by shaping it, in particular by a spring-like design of sections of the target, for example in the form of a leaf spring. Alternatively, the elasticity can also be achieved by forming sections with non-metallic elastic materials, for example elastomeric transition areas.

According to the invention, the target is arranged in the housing in such a way that it rests against the housing in an area that extends over the inductive sensor. The target is thus supported on the one hand on its support means, which are located for example on the printed circuit board or for example on a housing section below the printed circuit board, and on the other hand rests against the housing section extending over the inductive sensor. The target is compressed between the housing and support means within the elasticity range of the target.

The target is in a defined position relative to the inductive sensor due to its positioning on the associated support means, as the support means and printed circuit board with inductive sensor are in a stable position relative to each other at all times, as they are attached to the same components. The compression of the target between the housing and the support means of the target ensures reliable contact of the target with the housing at all times and thus reliable transmission of housing deformations when force is applied in this area to movements of the target. This is ensured by the elasticity of the target, which can also compensate for small manufacturing or assembly tolerances with regard to the distance between the housing and the inductive sensor. Furthermore, it is ensured that the position of the target to the inductive sensor remains fixed and in line with the specification at all times, as this positional relationship is determined by the local positioning of the bearing and not by the arrangement of the target on a housing part that may be subsequently mounted. Even if parts of the target are and remain movable during compression and subsequent deformation due to the application of force to the housing, the relationship of the target and its fixation to the support means is maintained at all times due to the flexibility of the target. The target deforms in itself, i.e. in its shape, which extends between the support means and the attachment to the housing. Due to the compression, the target adjusts itself in contact with the housing during assembly in relation to its contact with the housing itself but remains in the defined alignment with the inductive sensor at all times, which in turn does not change its position in relation to the support means of the target.

If, for example, the support means is provided on the printed circuit board itself, which also carries the inductive sensor, the positioning of the target relative to the inductive sensor is also fixed by this positional relationship of the support means. If the circuit board is then inserted into a housing part of the Actuation unit (e.g. a handle housing) and another housing part is fitted as a housing cover after assembly, the elastic target is compressed at this moment. The shape and elasticity of the elastic target is designed in such a way that it is compressed in any case when the housing cover is fitted but remains fixed in its position on the support means. This ensures that the target is always in the intended alignment with the inductive sensor even in the event of assembly deviations and, on the other hand, that mechanical contact between the target and housing is provided at all times in order to transfer deformations of the housing into a displacement of sections of the target, while the target remains unchanged and fixed in position on the support means due to its elasticity.

In a preferred embodiment of the invention, the inductive sensor is designed as a printed, sectionally spiral-shaped conductor track on the printed circuit board.

The design of the inductive sensor as a printed conductor track, which is guided in a spiral on the printed circuit board, enables a particularly flat and cost-effective design of the inductive sensor, since this is formed together with the other conductor tracks on the printed circuit board in a uniform process.

According to a preferred embodiment of the Actuation unit, the target has at least one fold or bend, wherein at least one section of the target is supported on a first side of the fold or bend on the support means and at least one other section of the target is supported on the other, second side of the bend on the housing.

The formation of a fold or fold-over in the material of the target can be achieved by a simple mechanical folding process during the manufacture of the target and ensures elasticity of the target, in particular along the course of the fold or fold-over and also in the area of the sections of the target extending therefrom.

It is particularly preferable for the target to be at least partially curved in the section adjacent to the housing, with the convex side of the curved section being supported on the housing.

The curved design of the target ensures that when the housing is deformed, it is possible for the target to slide in the curved section on the housing, so that the target can be deformed, and the target can also be reset with low friction when the force is removed.

In an advantageous further development of the invention, the target has at least three resilient mounting legs, wherein the section extending over the inductive sensor extends between the resilient mounting legs and wherein the mounting legs extend between the section extending over the inductive sensor and the support means.

In this arrangement, an area of the target extending between the legs is formed, for example, as a flat section, the legs connecting this section to the support means and the legs being resiliently deformable in themselves. The target can therefore deform elastically on the legs, whereby the legs have a certain spring effect. The legs can provide the elasticity in particular by shaping, for example by introducing S-shaped sections or wave-shaped or folded sections.

In a further preferred embodiment of the Actuation unit, the target is deformed in its section adjacent to the housing in such a way that at least one elevation is formed in the direction of the housing, the elevation preferably having the shape of a truncated cone or a rounded truncated pyramid.

Such a design of the target with an elevation in the direction of the housing again makes it possible for the target to only come into contact with the housing in a reduced area and for the forces to be transmitted from the housing to the target in a defined manner at this contact point, while ensuring that the housing slides on the target.

In a particularly preferred embodiment of the Actuation unit, the support of the target is formed exclusively on the printed circuit board.

The design of the bearing exclusively on the printed circuit board makes it possible to fit the printed circuit board with all components, including the target, and to insert this finished assembly into the housing. If a multi-part housing is used, the finished assembly can be inserted into the housing through a mounting opening, whereby the target is pressed together between the housing and its support means on the printed circuit board. If a multi-part housing is used, the printed circuit board with the target mounted on it can be inserted into a first housing part, fixed there and a second housing part placed on top as a cover, whereby the target is compressed between its support means and the attached housing part during attachment.

Particularly preferably, the support means of the target has receptacles or latching means that co-operate with complementary fastening sections of the target in order to fasten the target to the support means.

The formation of complementary fastening means on the target on the one hand and on the support means on the other makes it possible to arrange the target in a particularly reproducible positional relationship to the other components. For example, holders into which parts of the target are inserted ensure a reproducible and immovable position.

If the support means of the target have receptacles or latching means that co-operate with complementary fastening sections of the target in order to fasten the target to the support means, a particularly fast assembly capability is ensured, as the target can be fixed in its position without the waiting times that are required, for example, in the case of interlocking connections between the target and the support means.

In some applications, it is particularly advantageous if the target is fixed to the support means by means of material-to-material connections. Material-fit connections, which are produced by soldering or gluing, for example, are generally more complex to assemble, but enable the production of particularly durable connections. If, in addition, an electrically conductive coupling between the target and the support means is desired at certain points, this can be ensured by such a substance-to-substance connection using conductive connecting materials.

In a further development of the invention, the target has a galvanic coupling to contacts on the printed circuit board.

The galvanic coupling of the target via the support means or a separate contacting with contacts on the printed circuit board enables the control device to use the target for sensory purposes, for example, or to ensure that a predetermined potential can be maintained at the target at all times, for example in order to ground the target.

In a particularly preferred embodiment, the target is coupled to a control circuit on the printed circuit board, which may be the same control circuit that controls and evaluates the inductive sensor. In this embodiment, the control circuit temporarily controls the target as a capacitive sensor electrode.

The target therefore fulfils a dual function in this embodiment. On the one hand, it serves as a metallic target whose approach is detected by the inductive sensor and, with a time shift, it can be analyzed as a capacitive sensor electrode, for example to evaluate the contactless approach of an operator in the vicinity of the target. The control circuit can control the respective operating mode of the target, on the one hand as a target for an inductive sensor and on the other hand as an independent capacitive sensor in a time-division multiplexed operation or select the functions depending on a vehicle state.

While the invention can in principle be used in various Actuation units in a vehicle for user interaction, in a particularly preferred embodiment the Actuation unit is designed as a vehicle door handle. This vehicle door handle has a grippable handle on which a user can exert a force on a body component, for example a door or a tailgate. The circuit board with the inductive sensor mounted on it is located inside the handle, and the target is housed in the handle. The force exerted by the user on the handle, which affects the area of the handle where the housing is in contact with the target and compresses it, results in a detectable displacement of the target.

As already described above, the Actuation unit can basically have a one-piece housing in which, for example, a circuit board with an inductive sensor and a target is inserted. In a preferred embodiment of the invention, however, the Actuation unit is formed with a housing that is in several parts prior to assembly. The printed circuit board with the inductive sensor and the target is inserted and positioned in a first housing part, with the target resting on the support means on the printed circuit board or its support means on the first housing part. If a second housing part is placed as a cover on the first housing part, the components are encapsulated between the housing parts and the target is compressed between the second housing part and its support means in the first housing part or the printed circuit board.

The invention will now be explained in more detail with reference to the attached drawing.
Figures 1a to 1d show a schematic sectional view of an embodiment of the invention in the form of a motor vehicle door handle;
Figure 2 schematically shows the signal coupling between a control device and the other components of the first embodiment of the operating device according to the invention;
Figure 3a schematically shows a side view of a second embodiment of the invention, whereby the target is folded;
Figure 3b shows a schematic top view of the arrangement according to Figure 3a;
Figure 4 schematically shows a third embodiment with a target that is supported by flexible legs on a printed circuit board;
Figure 5 schematically shows a fourth embodiment with a target that is supported by flexible legs on a printed circuit board;
Figure 6 schematically shows a fifth embodiment with a target that is formed with elastic legs and a bend;
Figure 7 schematically shows a sixth embodiment with a target formed with straight legs for connection on a printed circuit board and an elastic fold;
Figure 8 schematically shows a seventh embodiment with a target formed with elastic legs and a fold with stop limitation;
Figure 9 schematically shows an eighth embodiment with a target formed with a truncated cone-shaped elevation and elastic legs;
Figure 10 schematically shows a ninth embodiment with a target that is formed with a truncated pyramid-shaped elevation and elastic legs;

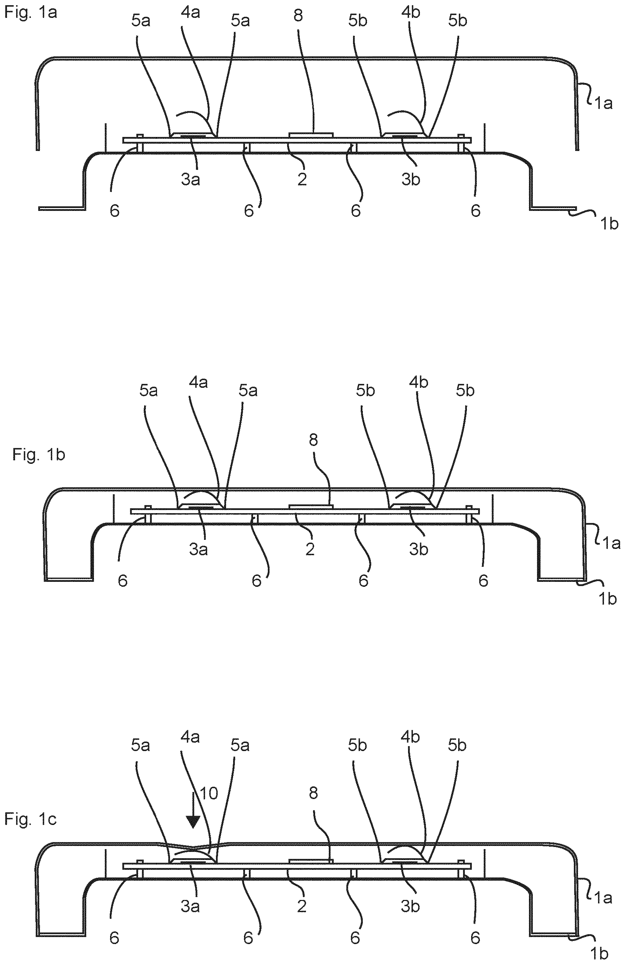

Figure 1a shows a first embodiment of the invention. A housing of the operating device is formed from the housing parts 1a and 1b, which are not yet connected to each other in the illustration in Figure 1a. After assembly, the housing parts 1a and 1b form a handle for a vehicle door handle, which can be attached to a body part of a vehicle.

Fastening means 6 are formed on the housing part 1b, to which a printed circuit board 2 is coupled. The printed circuit board 2 is thus fixed to the housing part 1b, whereby the fastening means 6 can, for example, have latching means or retaining means. A control device 8 in the form of a microcontroller is arranged on the printed circuit board 2. In addition to the components described here, further components may be arranged on the printed circuit board 2; furthermore, signal lines and supply lines from the printed circuit board to external components are not shown in order to concentrate the description on the Actuation unit according to the invention.

The printed circuit board also carries 2 inductive sensors 3a and 3B, which are arranged on the printed circuit board. Inductive targets 4a and 4b are arranged above the inductive sensors 3a and 3b. These inductive targets 4a and 4b are held in these support means 5a and 5b, which in this embodiment example are solder points on the printed circuit board 2, with which the inductive targets 4a and 4b are fastened and supported on the printed circuit board 2. As described above, a support means for an inductive target can also be formed in other ways, for example by pins, coupling means or also retaining means.

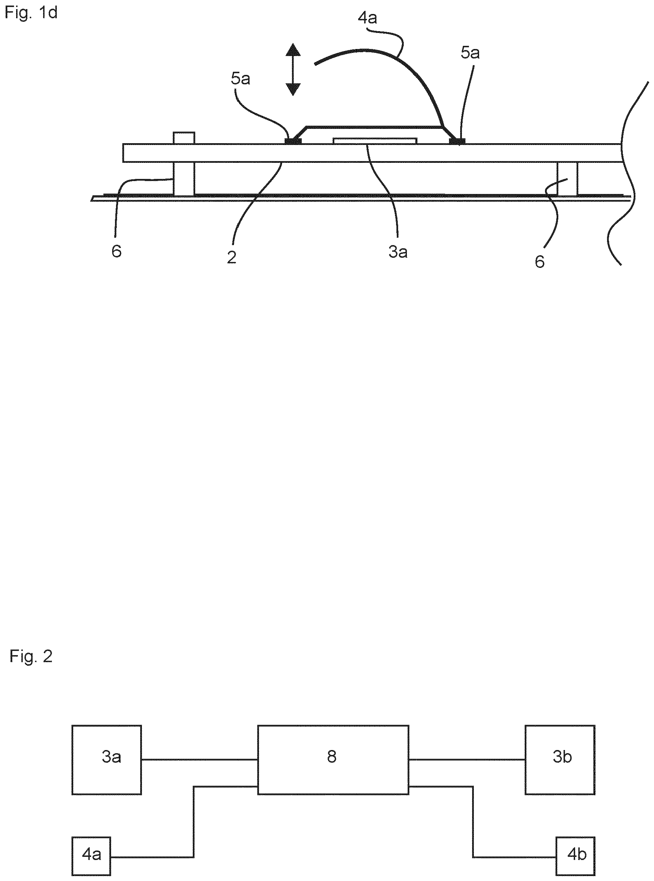

As can be seen in Figure 1a and shown more clearly in Figure 1d in the magnification of the left-hand inductive target 4a, the inductive target has a base section, from which the connections to the support means 5a and 5b extend, and an elastic section that extends from the printed circuit board towards the housing part 1a. This elastic section of the inductive target 4a or 4b is elastically deformable, so that the inductive target in this section, which extends above the inductive sensors 3a and 3b, is compressed between the housing part 1a and the inductive sensors 3a and 3b as well as the printed circuit board 2 when the housing is assembled. Figure 1b shows the fully assembled connection between the housing parts 1a and 1b, whereby it can be seen here that the elastic sections of the targets 4a and 4b are compressed between the housing part 1a and the inductive sensors 3a and 3b as well as the printed circuit board 2. More precisely, the compression of the component takes place between the bearings 5a and 5b and the part of the targets 4a and 4b that rests against the housing section 1a.

Figure 1c shows that the application of force to the housing section 1a in the direction and position of the arrow 10 leads to a slight deformation of the housing section 1a (exaggerated here), which results in compression of the target 4a. The deformation of the target 4a leads to a displacement of the metallic components of the target 4A, which is detected by the inductive sensor 3a, which reacts very sensitively to changes in the distance of metallic components in the detection range. It may be sufficient for the elastic deformation of the free section, as shown in Figure 1D, to exert leverage forces on the section of the target 4a that spans the inductive sensor 3a when the housing part 1a is pressed in. Alternatively, as shown in other figures, a cut-out can also be formed in the base section of the target 4a extending between the support points 5a in order to detect the elastic section of the target extending to the housing part 1a directly through the cut-out in the base section by the inductive sensor 3a located underneath.

Figure 2 illustrates the functional coupling of the control device 8 with the other functional components according to this embodiment of the invention. The control device 8 is coupled to the inductive sensors 3a and 3b in order to detect their inductance as a function of deformations of the respectively assigned target 4a or 4b. The control device 8 does not require control of the targets 4a and 4b to detect the inductance. In this embodiment example, however, it is provided that the control device 8 also has an electronic coupling with the targets 4a and 4b in order to operate them as capacitive sensor electrodes as an alternative to detecting the housing deformations, if required. This embodiment example thus provides that the control device 8 can operate the device according to the invention in a temporal multiplex or switchover mode in different ways, namely on the one hand by interrogating the inductive sensors 3a and 3b and on the other hand by operating the metallic targets 4a and 4b as capacitive sensors. The advantage of such a multifunctional use of the arrangement is that certain actuations, e.g. depending on the vehicle position or the vehicle status, enable a more reliable detection of a user's operating requests. Capacitive sensors already react to the approach of an object, e.g. the user's hand, while inductive sensors only react to the application of force to the housing and a displacement of the target. Both operating concepts can be used with this device in a customized and useful way.

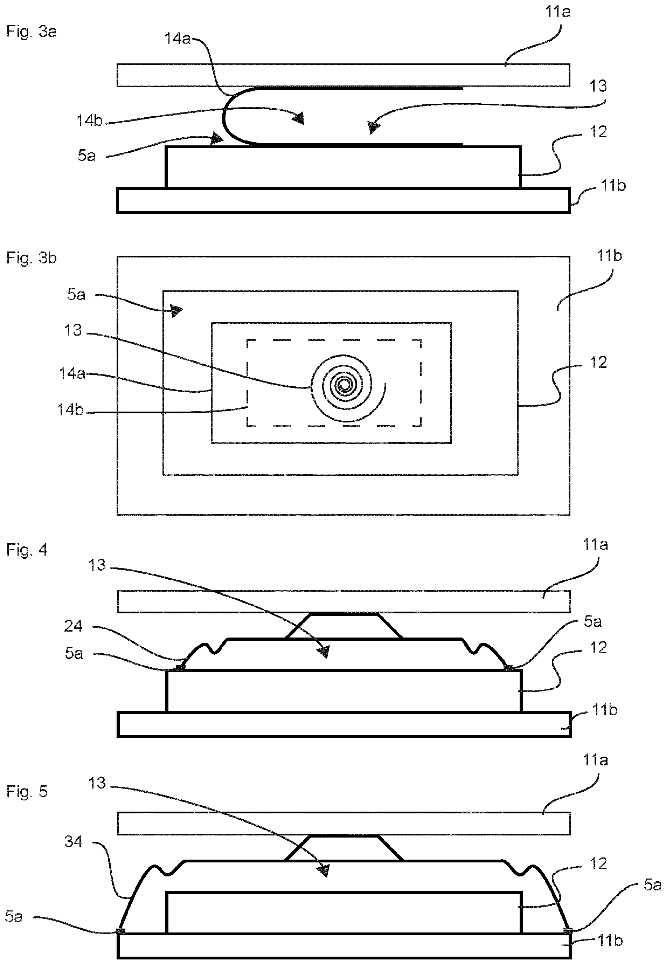

Figures 3a and 3b show a second embodiment of the combination of inductive sensor and associated target. The outer housing is formed here by the housing parts 11a and 11b, with a printed circuit board 12 resting directly on the lower housing part 11b in this illustration. As already explained above, the printed circuit board 12 can have a large number of other electronic components, with the illustration focusing on the components that are essential for the invention. In the present embodiment example, an inductive sensor in the form of a printed conductor spiral 13 is formed on the printed circuit board 12. While Fig. 3a shows a schematic sectional view of the components, the spiral-shaped conductor structure of the inductive sensor 13 is shown in the top view of Fig. 3b, in which the upper part of the housing 11a has been omitted so that only the remaining components are visible. In this embodiment example, a metallic target 14a is formed with a fold and is shaped like a U-shaped bracket, which rests on the printed circuit board 12 on the one hand and is pressed together by the housing part 11a on the other. The inductor target 14a has a cut-out 14b in its section or leg resting on the printed circuit board 12, so that the conductor spiral 13 underneath, as a metallic component, detects the upper section or leg of the inductor target 14a, which rests on the housing part 11a. The inductive sensor 13 thus detects the approach or removal of the upper section of the inductive target 14a when a force is applied to the housing part 11a through the cut-out 14b. In this embodiment example, it should be noted that the support means of the inductive target 14a on the printed circuit board 12 is formed by a flat support, whereby an attachment of the inductive target 14a on the printed circuit board can be secured in these sections, for example by soldering or gluing.

Figures 4 and 5 schematically show alternative embodiments of a target 24 and 34 respectively, whereby it is shown here that a support as in Figure 4 can be formed for an elastic inductive target on the printed circuit board. In Figure 5, however, the metallic target 34 is designed so that its resilient legs overlap the printed circuit board 12 and it is supported directly on the housing 11b. The embodiments in Figures 4 and 5 therefore differ in the location at which a support means for the target 24 or 34 is formed, while the resilient design of the targets 24 and 34 is similar. Both the target 24 and the target 34 have curved legs that extend from the center section to the respective support means and have wave-shaped deformation sections to ensure the elasticity of the targets. In both the target 24 and the target 34, a truncated cone-shaped projection is formed in the center section, which is intended for contact with the housing part 11a, in order to ensure a defined and precise deformation coupling of the targets 24 and 34 with the housing part 11a.

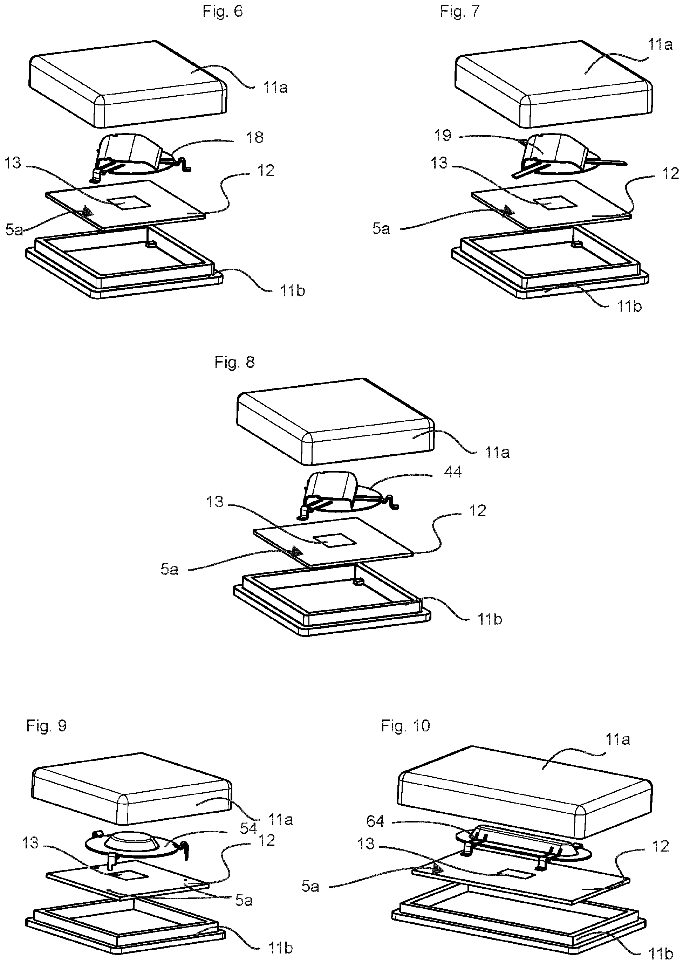

Figures 6 to 10 show a schematic, perspective view of further embodiments and embodiments of the invention, each of which differs in the shape of the targets.

In these representations, the housing with the housing parts 11a and 11b is designed as a cuboidal pressure actuation part to improve clarity, although the housing parts 11a and 11b can have any desired shape, in particular also the design shown in Figures 1a to 1d as a door handle.

The embodiments of Figures 6 to 10 differ in particular in how the targets shown there are mounted on a printed circuit board and which sections of the targets are elastic.

In Figure 6, the target 18 is formed with elastic, lateral legs, wherein the section of the target 18 supported by the legs is formed with a bending section in the form of a fold in order to form a contact section which bears against the housing part 11a. An inductive sensor 13 is arranged on the printed circuit board 12, which registers changes in the position of the target 18 that occur when a deformation force acts on the housing section 11a. In this case, the target 18 springs on its legs, which are mounted on the printed circuit board 12, and the inductance of the inductive sensor 13 changes.

Fig. 7 shows a similar configuration of the target 19 as in Fig. 6, but here the mounting legs are designed as elongated legs that extend from the center section of the target 19 and serve to mount the target on the printed circuit board 12.

In Fig. 8, the target 44 is again formed with elastic legs, but in the section in which the target rests against the housing part 11a and is compressed, it has a stronger development in the direction of the printed circuit board 12 in order to form a stop for deformation within the elasticity range in this way.

In Figure 9, a target is formed that is provided with a round center section and 3 spring legs, whereby the spring legs of the target 54 dip into associated bearing openings of the printed circuit board 12. The outer shape of the target 54 thus corresponds approximately to the embodiment example according to Figure 4, whereby here the support means are formed by receptacles for the spring struts in the printed circuit board.

Figure 10 shows an alternative embodiment in which a target is formed as an elongated sheet metal shape with 4 elastic legs, between which a center section extends. The center section of the target 64 is formed as a rounded truncated pyramid, which rests against the housing part 11a over a longer section and thus forms an enlarged actuating surface.

## Claims

1. Actuation unit comprising a housing (11a, 11b),
with a printed circuit board (2; 12), wherein the printed circuit board (2; 12) is mounted in the housing (11a, 11b),
with an inductive sensor (3a, 3b; 13) which is arranged on the printed circuit board
with a metallic target (4a, 4b; 14a; 18; 19; 24; 34; 44; 54; 64) which is assigned to the inductive sensor, wherein the target (4a, 4b; 14a; 18; 19; 24; 34; 44; 54; 64) extends in portions between the inductive sensor (3a, 3b; 13) and the housing (11a, 11b),
**characterized in that**
the target (4a, 4b; 14a; 18; 19; 24; 34; 44; 54; 64) is associated with support means (5a) on the printed circuit board (2; 12) and/or the housing, wherein the target (4a, 4b; 14a; 18; 19; 24; 34; 44; 54; 64) is rested on the support means (5a) and/or is attached to the support means,
wherein the target (4a, 4b; 14a; 18; 19; 24; 34; 44; 54; 64) is elastic at least in sections,
wherein the target (4a, 4b; 14a; 18; 19; 24; 34; 44; 54; 64) abuts against the housing (11a, 11b) in a section extending over the inductive sensor (3a, 3b; 13) and wherein the target (4a, 4b; 14a; 18; 19; 24; 34; 44; 54; 64) is in compressed state between the housing (11a, 11b) and the support means (5a) within the elasticity range of the target (4a, 4b; 14a; 18; 19; 24; 34; 44; 54; 64).

2. Actuation unit according to claim 1, wherein the inductive sensor (13) is in the form of a printed conductor track which is spiral-shaped, at least in sections, on the printed circuit board (12).

3. Actuation unit according to one of the preceding claims, wherein the target (4a, 4b; 14a; 18; 19; 44) has at least one bend or fold, wherein at least one section on a first side of the bend or fold is supported on the support means (5a) and wherein at least one section on the other, second side of the bend or fold is abutted on the housing.

4. Actuation unit according to one of the preceding claims, wherein the target (4a, 4b; 14a; 18; 19; 24; 34; 44; 54; 64) is at least partially curved in the section resting on the housing, wherein the convex side of the curved section is abutted against the housing.

5. Actuation unit according to one of the preceding claims, wherein the target (18; 19; 24; 34; 44; 54; 64) has at least three flexible mounting legs, wherein the section extending over the inductive sensor (13) extends between the flexible mounting legs and wherein the mounting legs extend between the section extending over the inductive sensor (13) and the support means (5a).

6. Actuation unit according to one of the preceding claims, wherein the target (24; 34; 54; 64) is shaped in the section of the target in contact with the housing (11a) in such a way that at least one protrusion is formed in the direction of the housing (11a), wherein the protrusion preferably has the shape of a truncated cone or a rounded truncated pyramid.

7. Actuation unit according to any one of the preceding claims, wherein the support means (5a) of the target are formed exclusively on the printed circuit board.

8. Actuation unit according to any one of the preceding claims, wherein the support means of the target comprise receptacles or latching means which cooperate with complementarily formed fastening portions of the target (in order to fasten the target to the support means.

9. Actuation unit according to one of the preceding claims, wherein the support means of the target comprise receptacles or latching means which cooperate with complementarily formed fastening portions of the target in order to fasten the target to the support means.

10. Actuation unit according to one of the preceding claims, wherein the target is fixed to the support means by interlocking connections.

11. Actuation unit according to any one of the preceding claims, wherein the target has a galvanic coupling to contacts on the circuit board.

12. Actuation unit according to claim 11, wherein the target is coupled to a control circuit, wherein the control circuit controls the target temporarily as a capacitive sensor electrode.

13. Actuation unit according to one of the preceding claims, wherein the Actuation unit is designed as a vehicle door handle, wherein the vehicle door handle has a grippable handle, in the interior of which the printed circuit board and the inductive sensor as well as the target are housed.

14. Actuation unit according to one of the preceding claims, wherein the housing is formed in several parts, and wherein the printed circuit board with the inductive sensor as well as the support means and the target are accommodated in a first housing part and wherein a second housing part is formed as a cover for the first housing part, wherein the target is abutted against the second housing part and is compressed between the support means and the second housing part.
